(19) Europäisches Patentamt
European Patent Office
Office européen des brevets

(11) Numéro de publication : **0 099 956 B1**

(12) # FASCICULE DE BREVET EUROPÉEN

(45) Date de publication du fascicule du brevet : **21.10.87**

(51) Int. Cl.⁴ : **H 04 L 25/24**, H 03 K 19/092

(21) Numéro de dépôt : **82430019.8**

(22) Date de dépôt : **28.07.82**

(54) **Récepteur de signaux et son utilisation dans un circuit de réception indiquant l'état de l'équipement connecté.**

(43) Date de publication de la demande :
**08.02.84 Bulletin 84/06**

(45) Mention de la délivrance du brevet :
**21.10.87 Bulletin 87/43**

(84) Etats contractants désignés :
**DE FR GB**

(56) Documents cités :
**US-A- 3 509 279**
**ELECTRONIC DESIGN, vol. 29, no. 7, 31 mars 1981, page 193, Waseca MN, Denville NJ (USA); R. TENNY: "Transistor circuits convert PIA lines to RS-232 ports and vice-versa"**
**J.G.GRAEME ET G.E.TOBEY: "Operational amplifiers",1971, pages 38-43, chapter 1, paragraphe 1.5, McGraw Hill, London (GB); "Differential amplifier stage signal characteristics".**
**IBM TECHNICAL DISCLOSURE BULLETIN, vol. 23, no. 4, septembre 1980, pages 1452,1453, New York (USA); Y.H. CHAN et al.: "Long line receiver".**
**IBM TECHNICAL DISCLOSURE BULLETIN, vol. 18, no. 2, juillet 1975, pages 406,407, New York (USA); A.E. BARISH et al.:"Line receiver with hysteresis"**

(73) Titulaire : **International Business Machines Corporation**
**Old Orchard Road**
**Armonk, N.Y. 10504 (US)**
**DE GB**
**Compagnie IBM FRANCE**
**5 Place Vendôme**
**F-75000 Paris 1er (FR)**
**FR**

(72) Inventeur : **Carsalade, Henri**
**7 Avenue Tournelli**
**F-06600 Antibes (FR)**
Inventeur : **Delaporte, François-Xavier**
**36 Chemin de Saint-Laurent**
**F-06800 Cagnes-sur-Mer (FR)**
Inventeur : **Pantani, Jean-Pierre**
**239 Boulevard du Mont Boron, B5**
**F-06300 Nice (FR)**

(74) Mandataire : **Lattard, Nicole**
**Compagnie IBM France Département de Propriété Intellectuelle**
**F-06610 La Gaude (FR)**

EP 0 099 956 B1

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue St-Denis, 75001 Paris, France

**Description**

Domaine Technique

La présente invention concerne un récepteur de signaux électriques de données pouvant être utilisé comme interface entre un équipement de communication de données DCE et un équipement terminal DTE et plus particulièrement un récepteur conforme aux normes internationales EIA RS 232C ou CCITT V24 qui peut être utilisé dans un circuit de réception comportant des circuits indiquant l'état de l'équipement auquel le récepteur est connecté.

Les normes EIA ont été établies pour pouvoir connecter des équipements fabriqués par différents constructeurs dans n'importe quel pays. La norme particulière EIA RS 232C a été établie pour fixer les caractéristiques électriques des signaux échangés entre différents équipements de traitement de données.

Conformément à cette norme les signaux binaires à envoyer en ligne par un circuit d'attaque de ligne ou reçus d'une ligne par un récepteur ont la particularité d'être différents des signaux binaires utilisés à l'intérieur des machines et ne sont liés à aucune technologie interne telle que TTL, ECL... Ils se définissent ainsi.

1) Les niveaux : la plage positive est comprise entre + 5 et + 15 volts, la plage négative est comprise entre — 5 et — 15 volts. Entre ces deux plages qui excluent le niveau 0 volt, se trouve la plage interdite.

2) L'impédance d'entrée R du dispositif de réception doit être résistive et telle que $3\ k\Omega \leqslant R \leqslant 7\ k\Omega$.

3) La pente doit être contrôlée, la tension en ligne, lors des transitions entre l'état haut et l'état bas doit varier à une vitesse bien définie comprise entre un minimum et un maximum très étroitement spécifiés, ceci pour permettre une cadence de signaux suffisamment élevée et cependant éviter les phénomènes connus de diaphonie que produiraient des flancs trop raides.

Art antérieur

La demande de brevet européen nº 801 066 341 déposée le 20 octobre 1980 et publiée le 10 juin 1981 sous le numéro 0 029 919 décrit un circuit d'attaque qui permet de générer les signaux binaires satisfaisant les critères définis par les normes EIA RS 232C.

Il existe des récepteurs qui satisfont les caractéristiques définies par la norme EIA RS 232C notamment celui proposé par Texas Instrument et décrit dans le Bulletin nº DLS 7 011 389 de novembre 1970 aux pages 8.79 à 8.81 ou celui décrit dans la revue Electronic Design, Volume 29 Numéro 7, 31 mars 1981, page 193.

De tels circuits sont du type comportant un transistor d'entrée fonctionnant en mode commutation et ne comporte pas de moyen permettant de connaître l'état de l'équipement duquel ils reçoivent les signaux.

Le brevet US-A-3 509 279 décrit un système de télécommunication comportant un récepteur de signaux binaires. Ce récepteur n'est pas particulièrement adapté aux caractéristiques des signaux binaires conformes aux normes EIA RS 232C.

Résumé de l'invention

Un objet de l'invention est donc de réaliser un récepteur satisfaisant les normes EIA RS 232C, et un circuit de réception comportant des moyens pour détecter l'état sous tension ou à l'arrêt de l'équipement duquel il reçoit les signaux.

Un autre objet de l'invention est de réaliser un tel circuit de réception dans lequel la puissance dissipée est très faible.

Un autre objet de l'invention est de réaliser un tel circuit de réception ayant une très bonne immunité au bruit.

Le récepteur intégré monolithique conforme à l'invention, selon la revendication 1, est destiné à recevoir sur son entrée les signaux d'une ligne présentant les caractéristiques définies par la norme EIA RS 232C et fournir sur sa sortie des signaux binaires utilisables dans les équipements de traitement de données. Le récepteur comprend un réseau d'entrée, recevant en entrée le signal de la ligne et fournissant en sortie un signal d'amplitude divisée par un facteur k, des moyens de génération de tensions de seuils pour générer des première et seconde tensions de seuils, un amplificateur différentiel ayant deux entrées la première recevant le signal de sortie du réseau d'entrée et la seconde recevant les tensions de seuils et des circuits de détection d'état ayant deux entrées et une sortie, une des entrées recevant le signal de sortie du récepteur et l'autre entrée recevant le signal de sortie du réseau d'entrée pour engendrer sur la sortie un signal indiquant l'état de l'équipement connecté envoyant les signaux en ligne.

L'amplificateur différentiel comprend un premier transistor dont l'émetteur est connecté par une source de courant T3 à une première tension d'alimentation, le collecteur est connecté à une seconde tension d'alimentation et la base est connectée à la sortie du réseau d'entrée, un second transistor dont l'émetteur est connecté par la même source de courant que le premier transistor à la première tension d'alimentation, le collecteur est connecté à une troisième alimentation par un puits de courant, la base reçoit les tensions de seuils, et un transistor de sortie dont l'émetteur est connecté à la troisième tension d'alimentation, le collecteur est relié par une résistance à la première tension d'alimentation et à la sortie du récepteur.

Les tensions de seuils sont générées par deux résistances disposées en série entre les première et troisième tensions d'alimentation, et un transis-

tor monté en diode ayant son collecteur et sa base reliés au point commun des résistances et son émetteur relié au collecteur du transistor de sortie. Le point commun des résistances sur lequel sont générées les tensions de seuils est connecté à la base du second transistor de l'amplificateur différentiel.

Les circuits de détection d'état comprennent un détecteur de niveau fournissant une première indication lorsque la tension d'entrée est voisine de zéro volt ou supérieure au seuil de commutation de l'amplificateur différentiel et une seconde indication lorsque la tension d'entrée est inférieure à ce seuil et un circuit de décision logique qui en fonction de l'indication fournie par le détecteur de niveau et de la sortie du récepteur engendre un signal à un premier niveau indiquant que le dispositif connecté est à l'arrêt lorsque le détecteur de niveaux fournit la première indication et que le niveau de la sortie du récepteur est haut et un signal à un second niveau indiquant que le dispositif connecté est sous tension lorsque le détecteur d'état fournit la seconde indication et que le niveau de la sortie du récepteur est haute ou que le détecteur d'état fournit la première indication et que le niveau de la sortie du récepteur est bas.

Les circuits de détection d'état comportent en outre des moyens de protection, l'un empêchant que le signal d'indication d'état généré sur leur sortie à partir des signaux fournis par le circuit de décision logique change de niveau lorsque l'équipement connecté étant sous tension le signal d'entrée du récepteur passe brièvement par zéro lors de la commutation du niveau haut au niveau bas et vice versa, l'autre évitant la même difficulté lorsque l'équipement connecté étant hors tensions de très brèves impulsions parasiteraient le signal d'entrée.

## Brève description des figures

La figure 1 représente le diagramme des signaux d'entrées reçus par le récepteur et des signaux de sortie du récepteur et des circuits de détection d'état.

La figure 2 représente le schéma du circuit de réception.

La figure 3 représente le schéma détaillé du récepteur conforme à l'invention.

La figure 4 représente la courbe de la tension de sortie du récepteur en fonction de la tension d'entrée du récepteur.

La figure 5 représente le schéma détaillé du circuit de réception comprenant le récepteur de la figure 4 et les circuits de détection d'état.

La figure 6 représente la courbe de la tension de sortie du circuit de détection d'état en fonction de la tension d'entrée du récepteur.

## Description détaillée de l'invention

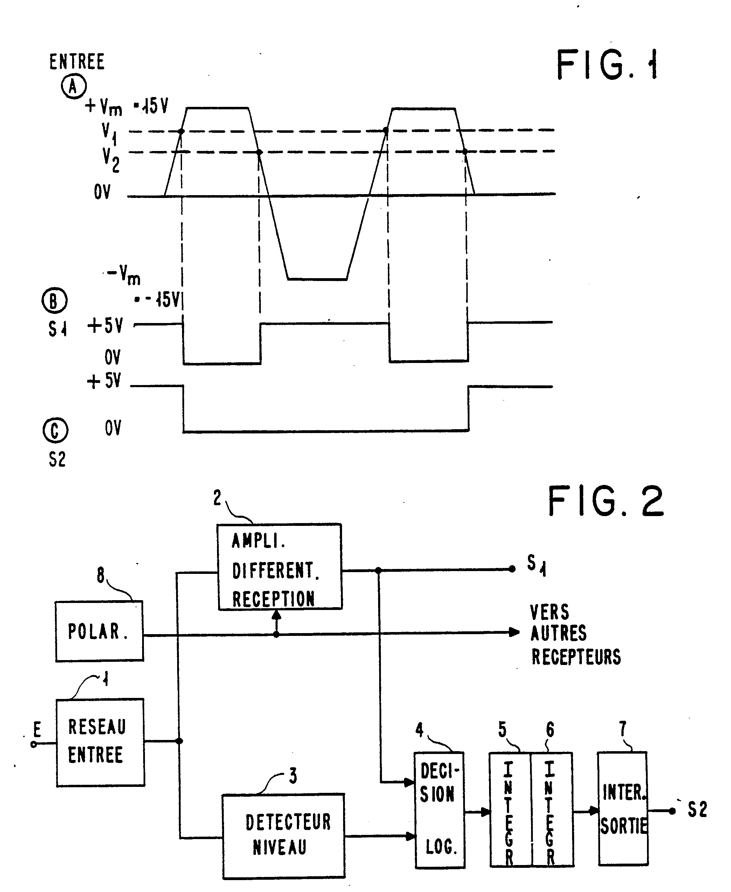

La figure 1 représente schématiquement le signal d'entrée du récepteur, reçu de la ligne reliant un équipement terminal de données DTE et un équipement de communication de données DCE ainsi que le signal de sortie délivré par le récepteur. Le signal d'entrée A a un niveau variant entre $+V_m = +15$ volts et $-V_m = -15$ volts. Le récepteur présente deux seuils de détection V1 sur le flanc de pente positive et V2 sur le flanc de pente négative et fournit sur sa sortie S1 un signal B rectangulaire de niveau bas 0 volt et de niveau haut + 5 volts.

Le signal d'entrée A n'est en fait à zéro volt que lorsque l'équipement connecté à la ligne et envoyant le signal au récepteur n'est pas sous tension. En conséquence, cet état ne peut être détecté par le récepteur, et conformément à l'invention il est détecté par des circuits distincts qui génèrent le signal C.

Sur la figure 2 est représenté le bloc diagramme du circuit de réception conforme à l'invention. Il comprend un réseau d'entrée 1 recevant sur la borne d'entrée E le signal A de la figure 1 et un amplificateur différentiel de réception 2 qui reçoit le signal de sortie du réseau d'entrée A et qui fournit sur sa borne de sortie S1 le signal B de la figure 1.

Le circuit de réception comprend en outre des circuits pour détecter l'état de l'équipement connecté à l'entrée E. Ces circuits comprennent un détecteur de niveau 3 qui reçoit le signal de sortie du réseau d'entrée 1, et un circuit de décision logique 4 qui reçoit sur l'une de ses entrées, la sortie de l'amplificateur différentiel de réception 2 et sur son autre entrée, la sortie du détecteur du niveau 3.

La sortie du circuit 4 est appliquée à deux circuits de protection 5 et 6. Un circuit d'interface de sortie 7 connecté à la sortie des circuits de protection fournit sur la borne de sortie S2 l'indication de l'état de l'équipement connecté à la borne E.

Un circuit de polarisation 8 qui peut être commun à plusieurs dispositifs de réception fournit à l'amplificateur différentiel 2 la tension de polarisation nécessaire à son fonctionnement.

Dans un mode de réalisation préféré, le circuit de décision 4, fournit un signal de sortie de niveau bas lorsque le signal d'entrée sur la borne E est actif, c'est-à-dire compris entre 3 volts et 15 volts en valeur absolue signifiant que l'équipement connecté est sous-tension. Dans le cas contraire son signal de sortie est au niveau haut et le signal sur S2 est au niveau haut.

La fonction des circuits de protection 5 est de rendre la détection d'état insensible au bruit sur la ligne, c'est-à-dire il faut une impulsion en ligne assez longue pour dire que l'équipement connecté est sous-tension. De plus, il ne faut pas que chaque fois que le signal A passe par 0, il y ait une indication d'arrêt de l'équipement connecté. Le circuit de protection 6 assure que cette indication ne soit fournit que lorsque le signal A reste à 0 pendant un temps suffisamment long.

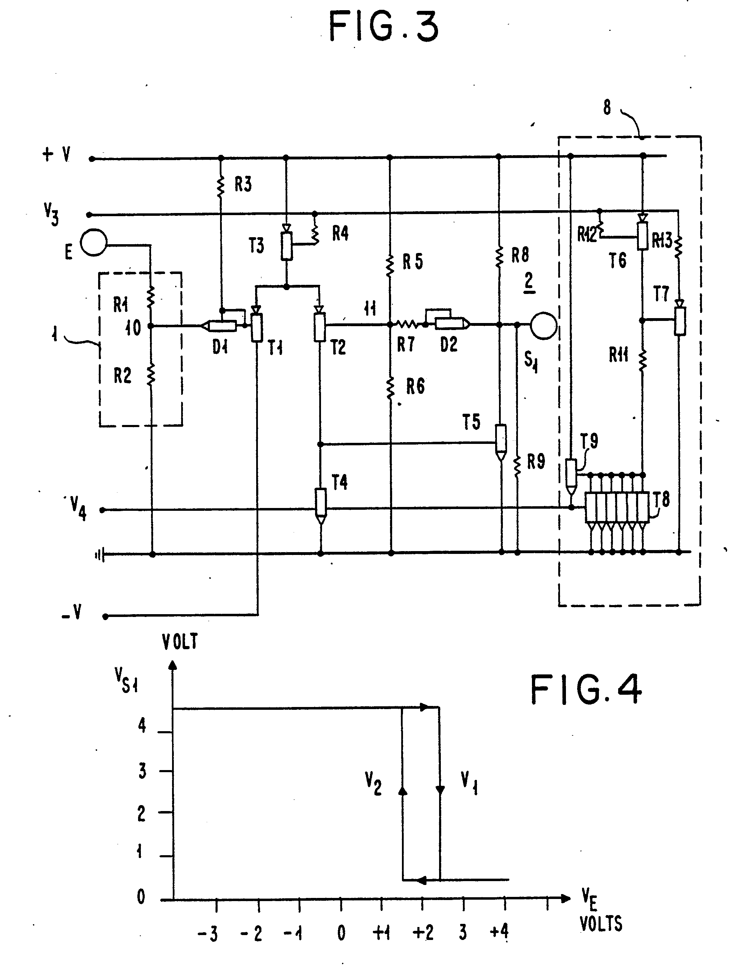

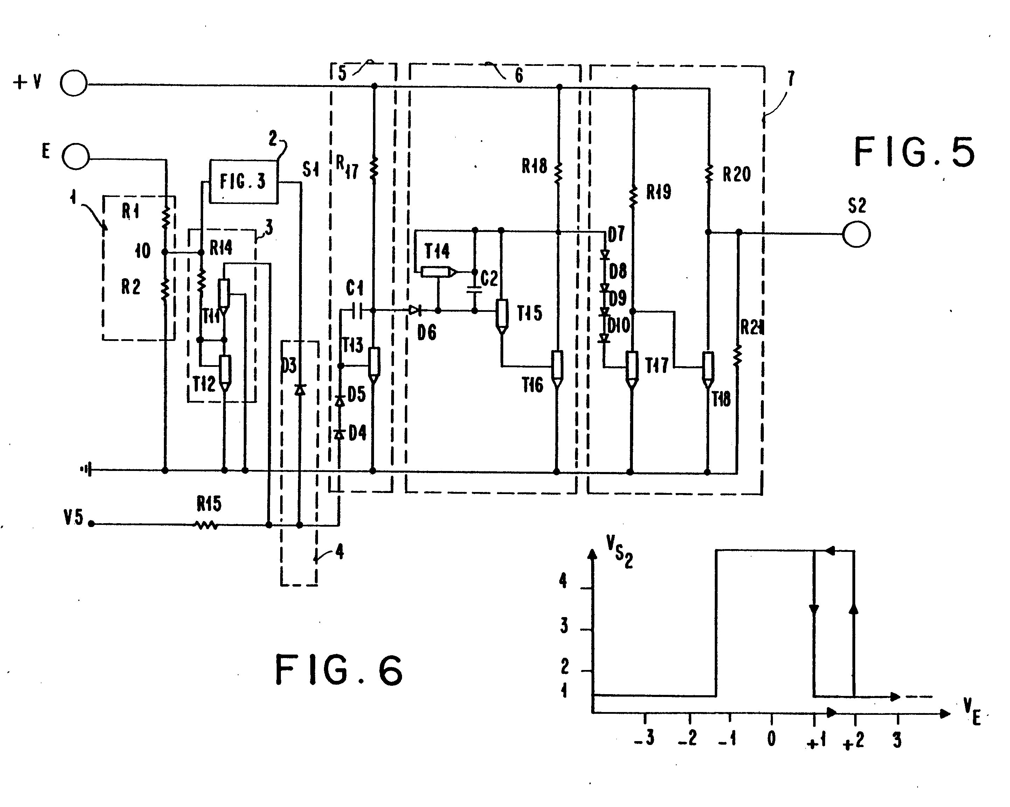

Sur la figure 3, on a représenté le réseau d'entrée 1, l'amplificateur différentiel de réception 2 et le circuit de polarisation 8.

Le réseau d'entrée 1 comporte deux résistances R1 et R2, d'égale valeur dans un mode de réalisation préféré, disposée en série entre l'entrée E et la masse. Le signal qui sera appliqué au récepteur est pris au point commun 10 des résistances. En conséquence, l'excursion de la tension d'entrée du récepteur 2 est divisée par un facteur k défini approximativement par le rapport des résistances R1 et R2 et égal à deux dans un mode de réalisation préféré.

Le circuit 2 comporte un amplificateur différentiel constitué par les transistors T1 et T2. La tension d'entrée divisée par 2, au point 10 est appliquée à la base de T1 par le transistor monté en diode D1. L'émetteur de D1 est connecté au point 10 et sa base et son collecteur reliés ensemble sont connectés d'une part à la base de T1 et d'autre part à la tension d'alimentation + V par une résistance R3. Le collecteur du transistor T1 est connecté à la tension d'alimentation — V.

Les émetteurs des transistors T1 et T2 sont reliés ensemble et leur point commun est relié par une source de courant comprenant le transistor T3 à la tension d'alimentation + V. Le collecteur du transistor T3 est connecté aux émetteurs des transistors T1 et T2, son émetteur est connecté à la tension + V et sa base est connectée à la tension de polarisation V3 par une résistance R4.

Le collecteur du transistor T2 est connecté au collecteur d'un transistor T4, dont la base reçoit la tension de polarisation V4 et l'émetteur est connecté à la masse.

La base du transistor T2 est connectée au point commun 11 de deux résistances R5 et R6 disposées en série entre l'alimentation + V et la masse.

Le point 11 est relié par une résistance R7 au point commun de la base et du collecteur d'un transistor D2 monté en diode, dont l'émetteur est connecté à la sortie S1.

Une résistance R8 est disposée entre la tension + V et la sortie S1 et une résistance R9 est disposée entre S1 et la masse. Un transistor de sortie T5 a son collecteur connecté à S1, son émetteur connecté à la masse et sa base connectée au collecteur de T2.

Le circuit de polarisation 8 fournit les tensions de polarisation V3 et V4. Il comprend une résistance de polarisation R11 et un premier circuit miroir de courant constitué par les transistors T6 et T7 dans lequel T6 est appairé avec la source de courant T3. L'émetteur du transistor T6 est connecté à la tension + V sa base est reliée à une borne d'une résistance R12, son collecteur est relié à une borne de la résistance R11 et à la base du transistor T7. L'émetteur du transistor T7 est relié à une borne d'une résistance R13, et son collecteur est relié à la masse. Les deux résistances R12 et R13 ont leurs autres bornes reliées ensemble et la tension V3 est obtenue à leur point commun.

Le circuit de polarisation comprend un autre miroir de courant diviseur, constitué par un transistor T9 et n transistors T8, disposés en parallèle et ayant leurs collecteurs reliés à la résistance R11, leurs émetteurs reliés à la masse et leurs bases connectées à l'émetteur du transistor T9. Dans le mode de réalisation préféré n = 6. La base de T9 est connectée aux collecteurs des transistors T8 et son collecteur est relié à la tension + V. Les bases des transistors T8 sur lesquelles est générée la tension de polarisation V4 sont reliées à la base du transistor T4 du récepteur. Le miroir de courant T9-T8 divise le courant dans R11 en six courants égaux qui seront écoulés chacun par l'un des six transistors T8.

Le premier miroir de courant fixe le courant collecteur du générateur de courant T3, le second miroir de courant fixe le courant dans le puits de courant T4.

Dans le mode de réalisation préféré, les transistors T1, T2, T6 et T7 sont de type PNP, et les transistors D1, D2, T4, T5, T8, T9 sont de type NPN. Les résistances ont les valeurs suivantes :

R1 = R2 = 2,17 kΩ
R3 = 50 kΩ
R4 = R12 = 0,45 kΩ
R5 = 22,7 kΩ
R6 = 6,5 kΩ
R7 = 6,5 kΩ
R8 = 9,75 kΩ
R9 = 13 kΩ
R11 = 15 kΩ

Les tensions d'alimentation + V et — V sont de + 8,5 volts et — 8,5 volts respectivement.

Le fonctionnement du récepteur est le suivant : lorsque la tension sur la base de T1 devient plus positive que celle sur la base de T2, le transistor T1 est bloqué et le transistor T2 conduit, ce qui rend conducteur le transistor de sortie T5. Dans le cas contraire, c'est-à-dire lorsque la tension sur la base de T1 devient plus négative que celle sur la base de T2, T1 devient conducteur et T2 et T5 sont bloqués.

Lorsque T5 est bloqué, la tension sur la base du transistor T2 est fixée à une première valeur de seuil VTH1 par les résistances R5 et R6. Lorsque la tension + V est de 8,5 volts cette valeur est fixée égale à 1,88 volts. Lorsque le transistor T5 est conducteur, la diode D2 est polarisée dans le sens direct si bien qu'un courant circule dans la résistance R7 ce qui abaisse la tension sur la base du transistor à une seconde valeur de seuil VTH2 égale à 1,38 volts dans le mode de réalisation préféré.

Ceci permet donc d'avoir un hystérésis de 0,5 volt approximativement sur le signal à la sortie 10 de l'atténuateur, ce qui correspond à 1 volt sur le signal à l'entrée E.

Lorsqu'aucun signal n'est appliqué à l'entrée, T1 conduit, T5 et T2 sont bloqués et le signal sur la sortie S1 est à un niveau haut qui est déterminé par la tension + V, et qui est fixé à 5 volts approximativement lorsque + V est égale à 8,5 volts.

A ce moment, le seuil sur la base de T2 est égal à VTH1 soit 1,88 volts.

Lorsque l'équipement connecté est mis sous tension et envoie un signal à l'entrée E, le seuil

reste fixé à VTH1 et lorsque la tension d'entrée sur la base de T1 devient supérieure à VTH1, T1 se bloque et T2 et T5 conduisent, en conséquence le niveau du signal sur la sortie S1 devient bas, soit approximativement 0 volt et le seuil sur la base de T2 est fixé à VTH2. Le récepteur restera dans cet état tant que le niveau du signal sur la base de T1 sera supérieur à VTH2.

Lorsque le niveau du signal sur la base de T1 devient inférieur au seuil VTH2, T1 conduit et T2 est bloqué ainsi que T5, le niveau du signal de sortie devient haut. Le seuil sur la base de T2 redevient égal à VTH1.

La diode d'entrée D1 provoque un décalage de la tension sur la borne 10 appliquée à la base du transistor T1, pour que la commutation du récepteur se fasse pour un signal d'entrée sur la borne E inférieur à + 3 volts au maximum, conformément aux exigences de la norme EIA RS 232C. En l'absence de diodes cette commutation se ferait pour un signal d'entrée supérieur à 2VTH1, soit 3,76 volts sur le flanc de pente positive et 2VTH2, 2,76 volts sur le flanc de pente négative.

Le transistor T3 est un générateur de courant pour les transistors T1 et T2, et il fournit un courant égal à celui du transistor T6 du miroir de courant du circuit de polarisation, qui est égal au courant IR11 circulant dans la résistance R11.

Le transistor T4 est un puits de courant pour évacuer le courant du transistor T2 lorsqu'il se bloque et accélérer le blocage du transistor T5.

Le courant collecteur du transistor T4 est égal à 1/6 du courant dans la résistance R11, du fait de l'arrangement des six transistors T8 en parallèle. Ceci pour éviter d'évacuer tout le courant collecteur du transistor T2 lorsque celui-ci est conducteur et fourni à T5, un courant base égal aux cinq sixièmes du courant collecteur de T2, afin de rendre T5 conducteur.

Les résistances R8 et R9 permettent d'adapter le niveau vu à la borne S1 à une valeur compatible avec les caractéristiques d'entrée du circuit qui traitera le signal reçu.

La figure 4 représente le niveau du signal de sortie sur la borne S1 en fonction du niveau du signal d'entrée sur la borne E.

L'hystérésis d'entrée assure une protection du récepteur contre le bruit continu.

L'impédance d'entrée est, dans le mode de réalisation préférée, égale à 4,34 kΩ ± 15 %. En conséquence, on peut sans inconvénient ajouter à l'entrée des récepteurs un réseau résistance/capacité pour rendre le récepteur encore plus insensible au bruit tout en conservant une impédance d'entrée située dans la gamme recommandée par le standard EIA RS 232C à savoir 3 à 7 kΩ.

On va maintenant décrire en référence à la figure 5, le fonctionnement du détecteur d'état de l'équipement connecté à l'entrée E. Les circuits 1 et 2 sont ceux de la figure 3, et les circuits 3 à 7 de la figure 2 sont référencés sur cette figure.

Le circuit 3 de détection de niveau comprend une résistance 14 dont une borne est reliée au point 10 du réseau d'entrée 1 et l'autre borne est reliée à l'émetteur d'un transistor T11. Le collecteur de T11 est relié à une tension positive V5 par une résistance R15, et sa base est reliée à la masse. Un transistor T12 monté en diode, a son collecteur relié à l'émetteur de T11 et son émetteur relié à la masse.

Le circuit de décision logique 4 est constitué par une diode D3 dont la cathode est reliée à la sortie S1 du récepteur et l'anode est reliée au collecteur du transistor T11.

L'intégrateur de protection 5 comporte deux diodes en série D4 et D5, l'anode de D4 est reliée à la sortie du circuit 4 prise à l'anode de D3, la cathode de D5 est connectée à la base d'un transistor T13. Le collecteur de T13 est connecté à la tension + V par une résistance R17, son émetteur est connecté à la masse. Une capacité C1 relie le collecteur et la base de T13.

L'intégrateur de protection 6 comporte une diode D6 dont l'anode est reliée au collecteur du transistor T13 et la cathode à la base d'un transistor T14.

Le collecteur et l'émetteur de T14 sont connectés à une borne d'une capacité C2 dont l'autre borne est reliée aux bases du transistor T14 et d'un transistor T15, l'ensemble T14 et C2 constitue une capacité d'intégration. Le collecteur de T15 est relié au collecteur de T16 et son émetteur est relié à la base d'un transistor T16, le collecteur de T16 est connecté par une résistance R18 à la tension + V, les transistors T15 et T16 constituant un montage Darlington.

L'interface de sortie comprend quatre diodes D7 à D10 disposées en série et deux transistors T17 et T18. L'anode de D7 est connectée à la sortie de l'intégrateur 6 prise au collecteur de T16 et la cathode de D10 est connectée à la base de T17. L'émetteur de T17 est connecté à la masse, son collecteur est connecté par une résistance R19 à la tension + V, et à la base de T18. Le collecteur de T18 est connecté à la tension + V par une résistance R20 et son émetteur est connecté à la masse. Le collecteur de T18 est relié à la masse par la résistance R21.

La sortie S2 est prise au collecteur de T18.

Dans un mode de réalisation préféré tous les transistors de ce circuit sont du type NPN.

La tension V5 est égale à + 3 volts.

Les résistances ont les valeurs suivantes :

R14 ≃ 20 kΩ
R15 ≃ 60 kΩ
R17 = 40 kΩ
R18 = 108 kΩ
R19 = 20 kΩ
R20 = 8 kΩ
R21 = 10 kΩ

Le fonctionnement du circuit de détection d'état est le suivant :

Le signal à la borne 10 est appliqué à l'émetteur de T11 par la résistance d'injection R14. Si ce signal est voisin de 0 volt, c'est-à-dire compris entre ± 0,6 volt, le transistor T11 est bloqué. En conséquence, le courant fourni par la résistance R15 est injecté à la base de T13 par les diodes D4 et D5 car dans cette condition le niveau sur la borne S1 est haut et la diode D3 est bloquée. Le transistor T13 sera saturé. Les transistors T15 et T16 seront bloqués, le transistor T17 sera conducteur et le transistor T18 sera bloqué. Le niveau sur S2 sera donc haut indiquant que l'équipement connecté en E est à l'arrêt.

Si le signal à la borne 10 est inférieur ou égal à — 1,5 volt, ce qui correspond à un signal d'entrée de — 3 volts, le transistor T11 est conducteur et écoule à la masse le courant de R15. Dans cette hypothèse S1 est toujours au niveau haut et la diode D3 est bloqué. Le transistor T13 est bloqué. Les transistors T15 et T16 conduisent. Le transistor T17 est bloqué et T18 conduit donc. Le signal sur la sortie S2 est au niveau bas indiquant que l'équipement connecté en E est sous tension.

Si le signal à l'entrée E est supérieur à 3 volts, T11 est bloqué, et la sortie S1 au récepteur S1 au récepteur 3 est à un niveau bas, donc la diode D3 conduit.

Cette diode dérivera le courant de la résistance R15 à la masse. De la même façon que précédemment le transistor T13 est bloqué, les transistors T15 et T16 sont conducteurs. Donc T17 est bloqué et T18 est conducteur. Le niveau sur la sortie S2 est bas.

La fonction de la diode T12 disposée dans le circuit émetteur de T11 est de limiter la tension inverse appliquée sur la jonction base émetteur de T11 lorsque le signal sur l'entrée E est égale à sa valeur maximum de 15 volts.

En conséquence, lorsque le signal d'entrée est soit plus positif que + 3V ou plus négatif que — 3V, le niveau sur S2 sera bas indiquant que l'équipement connecté en E est sous tension. Tandis que si le signal à la borne 10 est compris entre ± 0,6 V ce qui correspond à un signal d'entrée compris entre ± 1,2 V, le niveau sur S2 est haut indiquant que l'équipement connecté en E est à l'arrêt.

Cependant cette dernière indication ne doit pas être obtenue lorsque le signal d'entrée en E passe par zéro. Il est nécessaire d'éviter toutes les pointes qui pourraient apparaître dans le signal de sortie sur S2 lorsque le signal d'entrée passe par zéro. C'est le rôle de la diode D6 des transistors T14 et de la capacité C2.

En supposant que le signal d'entrée soit supérieur à 3 volts, comme indiqué précédemment T13 est bloqué, la diode D6 conduit et les transistors T15 et T16 sont conducteurs.

Si le signal d'entrée revient au voisinage de 0 volt, T13 deviendra instantanément conducteur et la diode D6 bloquée. Pendant un petit moment, T15 et T16 continueront à être conducteurs à cause de l'effet de la capacité C2 qui avait été chargée par l'intermédiaire de la résistance R17. La capacité fournira la quantité de courant nécessaire pour que les transistors T15 et T16 restent conducteurs.

A cause de la décharge de la capacité, la tension sur les collecteurs de T15 et T16 croîtra lentement.

Si dans l'intervalle, le signal d'entrée passe ensuite à — 3 volts, T13 sera à nouveau bloqué, et la diode D6 deviendra conductrice avant que la tension sur le collecteur des transistors T15 et T16 soit suffisamment élevée pour changer l'état du circuit 7 et aucune pointe de tension ne sera engendrée en sortie.

Par contre si, le signal d'entrée reste au voisinage de 0 volt, la capacité formée par C2 et T14 se déchargera complètement et, la tension sur le collecteur, de T15 et T16 deviendra suffisamment élevée (approximativement + 3,5 volts) et un niveau logique haut apparaîtra à la sortie pour rendre conducteur le transistor T17 par l'intermédiaire des diodes D7 et D10.

De plus, lorsque S2 indique que l'équipement connecté en E est à l'arrêt, il ne faut pas que cet état soit perturbé par une impulsion aléatoire et parasite qui pourrait apparaître sur la ligne de liaison entre l'équipement de communication DCE et l'équipement terminal DTE.

C'est le rôle de la capacité C1 connectée entre la base et le collecteur du transistor T13.

En supposant que le signal d'entrée en E soit compris entre + 1,2 volts, T13 est conducteur.

Si le signal d'entrée devient soit plus grand que + 3 volts soit plus petit que — 3 volts, T13 deviendra très vite bloqué car le courant de R5 sera absorbé, soit par T11 (VE < — 3V) soit par la sortie S1 (VE > +3V). Grâce à la capacité C1 en fait la base de T13 restera alimentée momentanément et ainsi T13 restera conducteur.

Si dans l'intervalle, le signal d'entrée redevient ensuite voisin de zéro volt, la base de T13 sera toujours maintenu conducteur. Ainsi, aucune pointe de tension ne sera engendrée en sortie.

Par contre, si le signal reste durablement plus grand que + 3 volts et moins grand que — 3 volts, T13 se saturera, les transistors T15 et T16 seront bloqués, le transistor T17 sera conducteur et le transistor T18 sera bloqué. Le niveau sur S2 sera haut et le circuit détectera une activité sur la ligne de liaison.

Un des avantages du dispositif de l'invention est qu'il peut être facilement intégré et réalisé sous forme monolithique.

Une interface pour la liaison entre un équipement DCE tel qu'un modem et un équipement terminal DTE comporte un ensemble de circuits d'attaque tel que décrit dans la demande de brevet européen déjà citée et de circuits récepteurs, les circuits d'attaque générant les signaux à envoyer et les récepteurs recevant les signaux. En effet pour une liaison DCE à DTE, il y a plusieurs fils, à savoir des fils destinés à transmettre les données proprement dites et des fils de contrôle associés. Par exemple du côté entrée du modem, il faut un circuit d'attaque pour envoyer les données au terminal et un récepteur pour recevoir les données du terminal et à chacun des fils de contrôle il faut un récepteur ou un circuit d'attaque suivant la nature du fil de contrôle, à savoir un circuit d'attaque lorsque ce fil est destiné à fournir un signal au terminal et un récepteur lorsqu'il est destiné à recevoir un signal du terminal.

Dans une microplaquette disposée dans un module 1/2 pouce, peuvent être intégrés quatre circuits d'attaque et quatre récepteurs auxquels est associé un circuit de détection de l'état de l'équipement connecté par exemple.

Les seuils des récepteurs sont bien définis, la puissance dissipée est très faible.

**Revendications**

1. Récepteur intégré monolithique (1, 2, 8) destiné à recevoir sur son entrée (E) les signaux d'une ligne présentant les caractéristiques définies par la norme EIA RS 232C ayant des niveaux dont la plage positive est comprise entre + 5 et + 15 Volts et la plage négative est comprise entre — 5 et — 15 Volts ; et fournir sur sa sortie (S1) des signaux binaires utilisables dans les équipements de traitement de données, ce récepteur étant du type comportant un réseau d'entrée (1), recevant en entrée (E) le signal de la ligne et fournissant en sortie (10) un signal d'amplitude divisée par un facteur k, et étant caractérisé en ce qu'il comprend :

des moyens de génération de tensions de seuils (R5, R6, D2) pour générer des première et seconde tensions de seuils qui dépendent du niveau du signal d'entrée,

un amplificateur différentiel ayant deux entrées, la première recevant le signal de sortie du réseau d'entrée et la seconde recevant les tensions de seuils, et une sortie qui constitue la sortie (S1) du récepteur,

des circuits de détection d'état (3 à 7) ayant deux entrées et une sortie (S2), une des entrées recevant le signal de sortie (51) du récepteur et l'autre le signal de sortie du réseau d'entrée pour engendrer sur la sortie (S2) un signal indiquant que l'équipement connecté envoyant les signaux en ligne est sous tension ou à l'arrêt.

2. Récepteur selon la revendication 1, caractérisé en ce que :

l'amplificateur différentiel comprend :

un premier transistor (T1) dont l'émetteur est connecté par une source de courant (T3) à une première tension d'alimentation (+ V), le collecteur est connecté à une seconde tension d'alimentation (— V) et la base est connectée à la sortie (10) du réseau d'entrée ;

un second transistor (T2) dont l'émetteur est connecté par la même source de courant que le premier transistor à la première tension d'alimentation (+ V) et le collecteur est connecté à une troisième alimentation (la masse) par un puits de courant et la base reçoit les tensions de seuils ;

un transistor de sortie (T5) dont l'émetteur est connecté à la troisième tension d'alimentation, le collecteur est relié par une résistance (R8) à la première tension d'alimentation (+ V) et à la sortie (S1) du récepteur, et

les moyens de génération de seuils comprennent :

deux résistances (R5 et R6) disposées en série entre les première et troisième tensions d'alimentation et ayant un point commun sur lequel sont générées les tensions de seuils ; et

un transistor (D2) monté en diode ayant son collecteur et sa base reliés au point commun des résistances et son émetteur relié au collecteur du transistor de sortie (T5).

3. Récepteur selon la revendication 2, caractérisé en ce qu'il comprend un circuit de polarisation (8) comprenant :

un premier miroir de courant (T6, R12 ; T7, R13 ; R11) définissant le courant dans la source de courant (T3) égal à une première valeur (IR11), et

un second miroir de courant (T9, T8) définissant le courant dans le puits de courant à une seconde valeur (IR11/n).

4. Récepteur selon l'une quelconque des revendications 2 ou 3, caractérisé en ce qu'il comprend un transistor (D1) monté en diode pour abaisser le seuil de commutation de l'amplificateur différentiel, ledit transistor ayant son collecteur et sa base reliés à la base du premier transistor de l'amplificateur différentiel et son émetteur relié à la sortie (10) du réseau d'entrée.

5. Circuit de réception selon l'une quelconque des revendications 1 à 4, caractérisé en ce que les circuits de détection d'état comprennent :

un détecteur de niveau (3) recevant le signal de sortie du réseau d'entrée comportant :

une première résistance d'alimentation (R14) connectée à la sortie du réseau d'entrée, et

un transistor de détection (T11), dont l'émetteur est connecté à la résistance d'alimentation, la base est connectée à la troisième tension d'alimentation et le collecteur est connecté par une seconde résistance d'alimentation (R15) à une quatrième tension d'alimentation, ledit transistor étant dans un premier état lorsque la tension d'entrée est voisine ou supérieure à zéro Volt, et dans un second état lorsque la tension d'entrée est négative,

un circuit de décision logique (4) comprenant une diode ayant une de ses électrodes (anode) connectée au collecteur du transistor de détection et son autre électrode (cathode) connectée à la sortie (S1) du récepteur, et fournissant sur sa sortie prise au collecteur du transistor de détection un signal ayant un premier niveau quand le transistor de détection est dans son premier état et que le signal de sortie du récepteur est au niveau haut, et ayant un second niveau indiquant que le dispositif connecté est sous tension lorsque le transistor de détection est dans son second état et que la sortie du récepteur est au niveau haut ou que le transistor de détection est dans son premier état et que la sortie du récepteur est au niveau bas.

6. Circuit de réception selon la revendication 5, caractérisé en ce qu'il comprend des moyens de protection recevant le signal de sortie du circuit de décision logique et empêchant au signal de détection d'état sur la sortie (S2) des circuits de détection d'état de changer de niveau lorsque le dispositif connecté étant sous tension, le signal d'entrée passe par 0 ou lorsque le dispositif connecté étant à l'arrêt, du bruit se produit sur la ligne.

7. Circuit de réception selon la revendication 6, caractérisé en ce que les moyens de protection comprennent :

un premier intégrateur comprenant un transistor (T13) ayant sa base connectée à la sortie du circuit de décision, son collecteur connecté par une résistance à la première tension d'alimentation et une capacité montée entre la base et le collecteur dudit transistor, ce transistor étant dans un premier état lorsque le signal de sortie du circuit de décision logique est à son second niveau et dans un second état lorsque le signal de sortie est à son premier niveau, et

un second intégrateur connecté au collecteur du transistor (T13) du premier intégrateur comprenant des moyens d'emmagasinage d'énergie (D6, T14, C2) et un premier et un second transistors montés en Darlington (T15, T16), la base du premier transistor étant reliée au collecteur du transistor du premier intégrateur par les moyens d'emmagasinage d'énergie, l'état des transistors montés en Darlington dépendant de l'état du transistor du premier intégrateur.

8. Circuit de réception selon la revendication 7, caractérisé en ce que les moyens d'emmagasinage d'énergie comprennent :

une diode (D6) dont une électrode est reliée au collecteur du transistor du premier intégrateur et l'autre électrode à la base du premier transistor du circuit Darlington,

une capacité (C2) montée entre le collecteur et la base du premier transistor du circuit Darlington, et

un transistor (T14) ayant son collecteur connecté à son émetteur et au collecteur du premier transistor du circuit Darlington et sa base connectée à la base dudit premier transistor du circuit Darlington, la diode étant conductrice lorsque le transistor du premier circuit intégrateur est dans son premier état pour charger la capacité afin que l'état des transistors du montage Darlington ne change pas lorsque, le dispositif connecté étant sous tension, le signal d'entrée passe par zéro.

**Claims**

1. A monolithic integrated receiver (1, 2, 8) for receiving through its input (E) the signals of a line meeting the requirements of EIA RS 232C Standard having levels positively ranging from + 5 to + 15 volts and negatively ranging from — 5 to — 15 volts and for supplying through its output (S1) binary signals usable in data processing devices, said receiver being of the type including an input network (1) receiving the line signal through its input (E) and supplying through its output (10) a signal the amplitude of which is divided by factor k, and being characterized in that it includes :

threshold voltage generating means (R5, R6, D2) for generating first and second threshold voltages in accordance with the input signal level,

a differential amplifier having two inputs, the first one receiving the signal outputted by the input network and the second one receiving the threshold voltages, and one input which is the receiver output (S1),

condition detecting circuits (3 to 7) having two inputs and one output (S2), one of the inputs receiving the receiver output signal from S1 and the second one receiving the signal outputted by the input network for generating through output (S2) a signal indicating that the connected device sending the signals over the line is either on or off.

2. A receiver according to claim 1 characterized in that :

the differential amplifier includes :

a first transistor (T1) the emitter of which is connected through a current source (T3) to a first supply voltage (+ V), the collector of which is connected to a second supply voltage (— V) and the base of which is connected to output (10) of the input network,

a second transistor (T2) the emitter of which is connected through the same current source as the first transistor, to first supply voltage (+ V) and the collector of which is connected to a third supply voltage (ground) through a current sink and the base of whiche receives the threshold voltages,

an output transistor (T5) the emitter of which is connected to the third supply voltage, the collector of which is connected through a resistor (R8) to first supply voltage (+ V) and receiver output (S1), and

the threshold generating means include :

two resistors (R5 and R6) mounted in series between the first and the third supply voltages and having a common node at which the threshold voltages are generated, and

a diode-mounted transistor (D2) having its collector and base connected to the common node of said resistors and its emitter connected to the collector of output transistor (T3).

3. A receiver according to claim 2 characterized in that it includes a biasing circuit (8) comprising :

a first current mirror (T6, R12, T7, R13, R11) setting current in current source (T3) to a first value (IR11), et

a second current mirror (T9, T8) setting current in the current sink to a second value (IR11/n).

4. A receiver according to any one of claims 2 and 3 characterized in that it includes a diode-mounted transistor (D1) for decreasing the switching threshold of the differential amplifier, said transistor having its collector and base connected to the base of the first transistor of the differential amplifier and its emitter connected to output (10) of the input network.

5. A receiving circuit according to any one of claims 1 to 4 characterized in that the condition detecting circuits include :

a level detector (3) receiving the signal outputted by the input network comprising :

a first supply resistor (R14) connected to the output of the input network and

a detecting transistor (T11) the emitter of which is connected to the supply resistor, the base of which is connected to the third supply voltage and the collector of which is connected to a fourth supply voltage through a second supply resistor (R15), said transistor being set in a first condition when the input voltage is close to or exceeds zero volt and in a second condition when the input voltage is negative,

a logic decision circuit (4) comprising a diode having one of its electrodes (anode) connected to the collector of the detecting transistor and its second electrode (cathode) connected to output (S1) of the receiver, and supplying through its output taken from the collector of the detecting transistor a signal at a first level when the detecting transistor is set in its first condition and the receiver output signal is high and at a second level indicating that the connected device is on when the detecting transistor is set in its second condition and the receiver output is high or the detecting transistor is set in its first condition and the receiver output is low.

6. A receiving circuit according to claim 5 characterized in that it includes protective means receiving the signal outputted by the logic decision circuit and preventing the condition detecting signal at output (S2) of the condition detecting circuits from changing of level when the connected device being on, the input signal goes through 0 or when the connected device being off, noise is generated over the line.

7. A receiving circuit according to claim 6 characterized in that the protective means include :

a first integrator comprising a transistor (T13) having its base connected to the output of the decision circuit, its collector connected to the first supply voltage through a resistor and a capacitor mounted between the base and the collector of said transistor, said transistor being set in a forst condition when the output signal of the logic decision circuit is at its second level and in a second condition when the output signal is at its first level, and

a second integrator connected to the collector of transistor (T13) of the first integrator comprising energy storage means (D6, T14, C2) and a first and a second Darlington-mounted transistors (T15, T16), the base of the first transistor being connected to the collector of the transistor of the first intregrator through the energy storage means, the condition of the Darlington-mounted transistors depending on the condition of the transistor of the first integrator.

8. A receiving circuit according to claim 7 characterized in that the energy storage means include :

a diode (D6) an electrode of which is connected to the collector of the transistor of the first integrator and the second electrode is connected to the base of the first transistor of the Darlington circuit,

a capacitor (C2) mounted between the collector and the base of the first transistor of the Darlington circuit and

a transistor (T14) having its collector connected to its emitter and to the collector of the first transistor of the Darlington circuit and its base connected to the base of said first transistor of the Darlington circuit, the diode being conducting when the transistor of the first integrator circuit is set in its first condition to charge the capacitor so that the condition of the transistors of the Darlington circuit does not change when the connected device being on, the input signal goes through zero.

**Patentansprüche**

1. Integrierter, monolithischer Empfänger (1, 2, 8), dazu bestimmt, an seinem Eingang (E) die Signale einer Linie zu empfangen, die die von der Norm EIA RS 232C definierten Kennzeichen aufweisen und auf Niveaus mit einem positiven Bereich zwischen + 5 und + 15 Volt sowie einem negativen Bereich zwischen — 5 und — 15 Volt liegen, und an seinem Ausgang (S1) binäre Signale zu erstellen, die in Datenverarbeitungsgeräten benutzt werden können, wobei dieser Empfänger von einem Typ ist, der ein Eingangsnetz (1) aufweist, das am Eingang (E) das Leitungssignal empfängt und am Ausgang (10) ein Signal ausgibt, dessen Amplitude durch einen Faktor k geteilt ist, und dadurch gekennzeichnet, dass er folgende Elemente umfasst :

Mittel zur Erzeugung von Schwellenspannungen (R5, R6, D2), um eine erste und eine zweite Schwellenspannung zu generieren, die vom Niveau des Eingangssignals abhängen,

einen Differentialverstärker mit zwei Eingängen, wobei der erste Eingang das Ausgangssignal des Eingangsnetzes und der zweite die Schwellenspannungen empfängt, sowie einen Augang, der den Ausgang (S1) des Empfängers darstellt,

Schaltkreise (3 bis 7) zur Zustandserkennung mit zwei Eingängen und einem Ausgang (S2), wobei einer dieser Eingänge des Ausgangssignal (S1) des Empfängers und der andere das Ausgangssignal des Eingangsnetzes empfängt, um am Ausgang (S2) ein Signal zu erzeugen, aus dem hervorgeht, ob das angeschlossene und Leitungssignale ausgebende Gerät ein- oder ausgeschaltet ist.

2. Empfänger nach Anspruch 1, dadurch gekennzeichnet, dass :

der Differentialverstärker aufweist :

einen ersten Transistor (T1), dessen Emitter über eine Spannungsquelle (T3) an einer ersten Versorgungsspannung (+ V) angeschlossen ist, während der Kollektor mit einer zweiten Versorgungsspannung (— V) und die Basis mit dem Ausgang (10) des Eingangsnetzes verbunden ist ;

einen zweiten Transistor (T1), dessen Emitter über dieselbe Spannungsquelle wie im Falle des ersten Transistors an der ersten Versorgungsspannung (+ V) angeschlossen ist, während der Kollektor über eine Stromkammer mit einer dritten Versorgungsspannung (Masse) verbunden ist und die Basis die Schwellenspannungen empfängt ;

einen Ausgangstransistor (T5), dessen Emitter mit der dritten Versorgungsspannung verbunden ist während der Kollektor über einen Widerstand (R8) mit der ersten Versorgungsspannung (+ V) und dem Ausgang (S1) des Empfängers verbunden ist, und

die Schwellenwert-Erzeugungsmittel weiter aufweisen :

zwei zwischen der ersten und der dritten Versorgungsspannung in Serie geschaltete Widerstände (R5 und R6) mit einem gemeinsamen Punkt, an welchem die Schwellenspannungen anstehen ; und

einen als Diode geschalteten Transistor (D2), dessen Kollektor und Basis mit dem gemeinsamen Punkt der Widerstände verbunden sind, während sein Emitter am Kollektor des Ausgangstransistors (T5) angeschlossen ist.

3. Empfänger nach Anspruch 2, dadurch gekennzeichnet, dass er einen Vorspannungskreis (8) mit folgenden Elementen aufweist :

einen ersten Stromspiegel (T6, R12, T7, R13, R11), der den Strom in der Stromquelle (T3) so definiert, dass er einem ersten Wert (IR11) gleich ist, und

einen zweiten Stromspiegel (T9, T8), der den Strom in der Stromkammer so definiert, dass er einem zweiten Wert (IR11/n) gleich ist.

4. Empfänger nach einem der Ansprüche 2 oder 3, dadurch gekennzeichnet, dass er einen als Diode geschalteten Transistor (D2) zum Herabsetzen der Schaltschwelle des Differentialverstärkers aufweist, wobei der Kollektor und die Basis des genannten Transistoren mit der Basis des ersten Transistors des Differentialverstärkers verbunden sind und der Emitter am Ausgang (10) des Eingangsnetzes angeschlossen ist.

5. Empfangsschaltkreis nach einem der Ansprüche 1 bis 4, dadurch gekennzeichnet, dass die Zustands-Erkennungskreise folgendes umfassen :

einen Niveausensor (3), der das Ausgangssignal des Eingangsnetzes empfängt und folgende Elemente aufweist :

einen ersten Versorgungswiderstand (R14), der mit dem Ausgang des Eingangsnetzes verbunden ist, und

einen Detektiertransistor (T11), dessen Emitter mit dem Versorgungswiderstand verbunden ist, während seine Basis mit der dritten Versorgungsspannung und sein Kollektor über einen zweiten Versorgungswiderstand (R15) mit einer vierten Versorgungsspannung verbunden sind, wobei der genannte Transistor in einen ersten Zustand übergeht, wenn die Eingangsspannung ca. 0 Volt oder mehr erreicht, und in einen zweiten, wenn die Eingangsspannung negativ ist,

einen Logik-Entscheidungskreis (4) mit einer Diode, deren eine Elektrode (Anode) mit dem Kollektor des Detektiertransistors verbunden ist während die andere (Kathode) am Ausgang (S1) des Empfängers liegt, wobei dieser Schaltkreis an seinem am Kollektor des Detektiertransistors abgenommenen Ausgang ein Signal erstellt, das ein erstes Niveau einnimmt, wenn der Detektiertransistor in seinem ersten Zustand ist und das Ausgangssignal des Empfängers auf hohem Niveau steht, und ein zweites Niveau, das anzeigt, dass die angeschlossene Vorrichtung unter Spannung steht, wenn der Detektiertransistor seinen zweiten Zustand eingenommen hat und das Ausgangssignal des Empfängers auf hohem Niveau liegt oder der Detektiertransistor seinen ersten Zustand eingenommen hat und das Ausgangssignal des Empfängers auf niedrigem Niveau liegt.

6. Empfangsschaltkreis nach Anspruch 5, dadurch gekennzeichnet, dass er Schutzmittel aufweist, die das Ausgangssignal des Logik-Entscheidungskreises empfangen und beim Zustands-Detektiersignal am Ausgangs (S2) der Zustands-Detektierkreise einen Niveauwechsel verhüten, wenn bei unter Spannung stehender angeschlossener Vorrichtung das Eingangssignal durch 0 geht oder wenn bei ausser Spannung stehender angeschlossener Vorrichtung ein Geräusch auf der Leitung auftritt.

7. Empfangsschaltkreis nach Anspruch 6, dadurch gekennzeichnet, dass die Schutzmittel weiter aufweisen :

einen ersten Integrator mit einem Transistor (13), dessen Basis mit dem Ausgang des Entscheidungskreises verbunden ist, während sein Kollektor über einen Widerstand an der ersten Versorgungsspannung angeschlossen ist, und einem Kondensator, der zwischen der Basis und dem Kollektor des genannten Transistors dazwischengeschaltet ist, wobei dieser Transistor seinen ersten Zustand einnimmt, wenn das Ausgangssignal des Logik-Entscheidungskreises auf seinem zweiten Niveau steht, und seinen zweiten Zustand, wenn das Ausgangssignal des Logik-Entscheidungskreises auf seinem ersten Niveau steht, und

einen zweiten Integrator, der mit dem Kollektor des Transistors (T13) des ersten Integrators verbunden ist, und ein erstes Energiespeichermittel (D6, T14, C2) sowie einen ersten und einen zweiten Transistor aufweist, die nach Darlington (T15, T16) geschaltet sind, wobei die Basis des ersten Transistors über die Energiespeichermittel mit dem Kollektor des Transistors im ersten Integrator verbunden ist und der Zustand der nach Darlington geschalteten Transistoren vom Zustand des Transistors im ersten Integrator abhängt.

8. Empfangsschaltkreis nach Anspruch 7, dadurch gekennzeichnet, dass die Energiespeichermittel aufweisen :

eine Diode (D6), deren eine Elektrode mit dem Kollektor des Transistors im ersten Integrator und die andere mit der Basis des ersten Transistors vom Darlington-Schaltkreis verbunden ist,

einen zwischen dem Kollektor und der Basis des ersten Transistors vom Darlington-Schaltkreis installierten Kondensator (C2), und

einen Transistor (T14), dessen Kollektor mit seinem Emitter und dem Kollektor des ersten Transistors vom Darlington-Schaltkreis und seine Basis mit der Basis des genannten ersten Transistors vom Darlington-Schaltkreis verbunden sind, wobei die Diode leitet, wenn der Transistor des ersten Integratorschaltkreises seinen ersten Zustand aufweist, um den Kondensator zu laden und so einen Zustandswechsel der Transistoren im Darlington-Schaltkreis zu vermeiden, wenn bei unter Spannung stehender angeschlossener Vorrichtung das Eingangssignal durch Null geht.

FIG. 1
ENTREE
A
+Vm = 15V
V1
V2
0V
-Vm
B
= -15V
S1
+5V
0V
+5V
C
0V
S2
FIG. 2
2
AMPLI.
DIFFERENT.
RECEPTION
S1
8
POLAR.
VERS
AUTRES
RECEPTEURS
1
E
RESEAU
ENTREE
4
5
6
7
DECI-
SION
LOG.
INTEGR
INTEGR
INTER.
SORTIE
S2
3
DETECTEUR
NIVEAU

FIG.3

+ V
$V_3$
E
R1
10
1
R2
R3
D1
T1
T3
R4
T2
11
R5
R7
D2
R6
R8
2
S1
T5
R9
T4
$V_4$
- V
8
R12
T6
R13
T7
R11
T9
T8
VOLT
$V_{S1}$
4
3
2
1
0
$V_2$
$V_1$
$V_E$
VOLTS
-3
-2
-1
0
+1
+2
3
+4

FIG.4

FIG. 5
+V
E
1
R1
10
R2
2
FIG. 3
S1
3
R14
T11
T12
D3
4
V5
R15
5
R17
C1
T13
D5
D4
6
T14
C2
D6
T15
R18
T16
7
R19
D7
D8
D9
D10
T17
R20
T18
R21
S2
FIG. 6
$V_{S_2}$
4
3
2
1
-3
-2
-1
0
+1
+2
3
$V_E$